# EUROPEAN PATENT SPECIFICATION

(11) **EP 2 035 897 B1**
(45) Date of publication and mention of the grant of the patent: **28.10.2015**
(21) Application number: 07764994.5
(22) Date of filing: 02.07.2007
(51) Int. Cl.: G03F 7/20

(54) **Method for revising or repairing a lithographic projection objective**
Verfahren zur Revidierung bzw. Reparatur eines lithographischen Projektionsobjektivs
Procédé de révision ou de réparation d'un objectif de projection lithographique

(30) Priority: 03.07.2006 US 818396 P
(43) Date of publication of application: 18.03.2009
(73) Proprietor: Carl Zeiss SMT GmbH, 73447 Oberkochen (DE)
(72) Inventor: ROGALSKY, Olaf, 73447 Oberkochen (DE); BITTNER, Boris, 91154 Roth (DE); PETASCH, Thomas, 73431 Aalen (DE); HAEUSSLER, Jochen, 89568 Hermaringen (DE)
(74) Representative: Witte, Weller & Partner Patentanwälte mbB
(86) International application number: PCT/EP2007/005837
(87) International publication number: WO 2008/003442

(56) References cited:
- EP-A- 1 231 516
- EP-A- 1 672 431
- US-A- 5 638 223
- US-A- 5 677 757
- US-A- 5 789 734
- US-A1- 2005 134 972

## Description

The invention relates to a method for revising or repairing a projection objective of a lithography projection exposure apparatus in the field.

Projection objectives are used in lithography projection exposure apparatuses for printing a precision circuit pattern on a substrate, for example a wafer, a plate or the like, coated with a photosensitive material. The circuit pattern to be printed is provided by an object referred to as reticle which is imaged by the projection objective onto the substrate. Projection objectives for such applications require very high optical performance.

A projection objective of a lithography projection exposure apparatus generally comprises a plurality of optical elements between an object plane and an image plane. Here the term "between" is to be understood as the plurality of optical elements being arranged in a manner that projection light coming from the object plane and arriving at the image plane reaches each optical element at least once. In the same way terms like "before" and "after" are understood to be in order of the propagating projection light. There are different types of projection objectives, namely dioptric, catoptric and catadioptric projection objectives. A dioptric projection objective only comprises refractive optical elements. A catoptric projection objective only comprises reflective optical elements. A catadioptric projection objective comprises refractive optical elements as well as reflective optical elements. The present invention is described herein with respect to dioptric and catadioptric projection objectives, the plurality of optical elements of which comprise at least one refractive optical element. In case there is an immersion liquid between the last optical element of the projection objective and the image plane the projection objective is said to be of immersion type. The immerison liquid itself does not count as an optical element. In case there are two immersion liquids and the last optical element of the projection objective is situated inbetween these two immersion liquids the projection objective is said to be of double immersion type. Hence any projection objective of double immersion type is a projection objective of immersion type, too.

After a certain period of time of use of a projection objective in lithography processes, one or more of the optical elements can exhibit degradations which can have various causes. For example, in projection objectives which are used in immersion lithography, the last optical element next to the image plane is in contact with an immersion liquid which can degrade the coating of the last optical element. Further, if the last optical element is made of calcium fluoride and pure water is used as the immersion liquid, the material of the last optical element itself is degraded by the immersion liquid, because pure water is very aggressive with respect to calcium fluoride. In case of double immersion the last optical element and the last but one optical element can be degraded by the immersion liquid.

Another possible degradation comes from the distribution of the integrated light intensity on the optical elements which can result in shape deformations of the optical elements as well as in changes of the index distribution in case the optical elements are of refractive type. This distribution is influenced by slit-like reticles, non-rotational symmetric illumination settings, e.g. dipole or quadrupole settings, and the kind of object, e.g. circuit patterns which are unidirectional.

Other lifetime induced degradations of optical elements can be alterations of the refractive index, stresses in the material of the optical elements, etc. Thus, after a certain lifetime, when the projection objective exhibits degradations which affect the high precision optical performance, the projection objective must be repaired or revised.

In conventional repairing methods, the whole projection objective is shipped from the customer who uses the projection objective in lithography exposure to the manufacturer, where the degraded projection objective was repaired by exchanging more or less all optical elements of the projection objective. Such a repairing method is very time consuming and leads to large downtimes at the customer which are not desirable. Further, an exchange of all of the plurality of optical elements is very cost expensive, and in view of the tremendous costs of a projection objective, such a repairing method is not acceptable to the customer, too.

Therefore, there is a need in a method for repairing a projection objective which can be performed in the field, i.e. at the customer's place where the projection objective is in use, and which does not require an exchange of all optical elements of the projection objective.

In most instances, a customer who uses the projection objective in lithography processes desires a repairing or revising of a degraded projection objective with as least as possible alteration of the so called fingerprint of the projection objective. The fingerprint of a single projection objective is to be understood as the set of characteristic image defects of this single projection objective or the set of specific characteristics of a single whole projection exposure system, respectively.

On the other hand, in some instances, the customer desires to have adapted the image defect budget to a specific reticle to be projected by the projection objective to the substrate, and/or to a certain illumination setting used in the lithography process. In some cases, it is desired to introduce certain image defects, like coma, in the image.

EP-A-1 231 516 discloses a method for determining the specification of a projection optical system, wherein target information is obtained which the optical apparatus is to achieve. Based on a target information, the specification of the projection optical system is determined by using one of a wave-front aberration amount and value corresponding to a wave-front aberration, which the projection optical system is to satisfy, as a standard. Further, a method for making a protection optical system is disclosed, wherein the method comprises determining the specification of the projection optical system according to the specification-determining method, and adjusting the projection optical system to satisfy the specification. Finally, a computer system is disclosed comprising a first computer into which target information that the optical apparatus is to achieve is inputted, and a second computer which is connected to the first computer via a communication path and determines the specification of the projection optical system used in the optical apparatus based on the target information received from the first computer via the communication path by using one of a wave-front aberration amount and value corresponding to a wave-front aberration, which the projection optical system is to satisfy, as a standard.

US 2005/0134972 A discloses a replacement apparatus for an optical element mounted between two adjacent optical elements in a lithography objective which has a holder for the optical element to be replaced, which holder can be moved into the lithography objective through a lateral opening in a housing of the same.

US 5 638 223 A discloses a projection type exposure apparatus for illuminating a mask formed with a pattern with an illumination light having a predetermined wavelength area and forming an image of the pattern on a substrate through a projection optical system. The apparatus comprises a projection optical system incorporating a plurality of lens barrel units each housing one or more optical elements. Each lens barrel unit is mounted in the projection optical system such that it is attachable thereto and detachable therefrom.

EP-A-1 672 431 discloses a lithographic apparatus, which includes different movable lenses that can be placed in the path of a radiation beam to change a magnification of the projection system. By changing the magnification of the projection system an area of a substrate exposed per pixel can be adjusted, and a throughput of the system is optimized thereby.

US 5 677 757 A discloses a projection exposure apparatus which is provided with an optical filter changing member for selecting one of a plurality of optical filters that change at least one of optical characteristics of light from the mask by respective amounts which are different from each other. The optical characteristics include an amplitude distribution, a phase distribution and a condition of polarization. The projection objective further has a correcting member-changing member for selecting one of a plurality of image-forming characteristic correcting members that correct image-forming characteristics of the protection objective.

US 5 789 734 discloses an exposure apparatus wherein an image forming system forms an image of a pattern upon a photosensitive layer, and a detecting system detects a spherical aberration of the image forming system. The detected spherical aberration of the image forming system is adjusted or controlled in a suitable way, whereby correct pattern transfer aberration is assured.

EP-A-0 724 199 discloses a method of adjusting a projection objective, comprising measuring a distortion component of the projection objective, calculating a surface shape for a correction optical element in order to compensate for distortions of the image, removing the correction optical element from the projection objective, machining the correction optical element to the required surface shape, and rearranging the correction optical element at a position where the correction optical element has been arranged prior to removing same. This document does not deal with a method of repairing a projection objective.

Document US 6,333,776 B1 discloses a projection objective in which a correcting plate is disposed, which can be selectively inserted and withdrawn by a changing device. The correcting plate can be changed for another correcting plate stored in a storage unit according to need. The correcting plate has been polished so as to be capable of correcting random distortion. Here the term "random distortion" is understood to be the distortion of a projection objective under consideration which is generated by random variations of production parameters during the production of this projection objective. This document does not deal with a method for repairing a projection objective, either.

US 5,392,119 discloses a method of correcting a projection objective by using two corrector plates arranged in the projection objective. The first corrector plate is optimized to produce beam deflection, and the second correction plate is optimized to correct for aberrations measured previously. The method disclosed can be used for modifying existing projection objectives, for example in order to improve the optical resolution.

WO 2005/069055 A2 discloses projection objectives of immersion type having optical elements with refractive power as last optical elements.

WO 2006/121009 and WO 2006/126522 disclose projection objectives of double immersion type having plane parallel plates as last optical elements.

It is an object of the present invention to provide a method for revising/repairing a projection objective of a lithography projection exposure apparatus which can be carried out in the field.

It is another object of the present invention to provide a method for revising/repairing a projection objective of a lithography projection exposure apparatus which reduces downtimes of use of the projection objective at the customer.

It is another object of the present invention to provide a method for revising/repairing a projection objective of a lithography projection exposure apparatus which is less time consuming and/or less cost expensive.

It is another object of the present invention to provide a method for revising/repairing a projection objective of a lithography projection exposure apparatus which is capable of adapting the image quality of the projection objective according to the customer's needs.

According to the present invention, a method for revising or repairing a projection objective of a lithography projection exposure apparatus in the field is provided according to claim 1. The dependent claims define embodiments of this method.

The method according to the invention is based on the concept that only adverse effects of degraded optical components are compensated by an exchange of single optical elements without exchanging all of the optical elements. Thus, the method according to the invention is less time consuming and considerably reduces downtimes at the customer. The method is carried out in the field, i.e. at the customer, and the projection objective to be repaired/revised has not to be shipped to the manufacturer of the projection objective. Further, the method comprises an adjustment of the image quality of the projection objective to a quality which is desired by the customer so that it is possible to maintain the image quality of the original state of the projection objective, but also to alter the image quality by the revision/repairing procedure compared with the image quality of the original state of the projection objective.

The at least one first spare optical element is an optical element which is at least approximately adapted to the shape of the first optical element.

It is not necessary that the at least one first spare optical element suffers itself from degradations. However, the at least first spare optical element is to be selected properly from the optical elements of the optical system in order to compensate degradation effects of the optical system. Especially advantageous are positions close to a pupil plane of the optical system, close to a field plane, and planes between might be necessary, depending on the imaging settings used by the customer. The imaging settings, depending on mask and illumination setting, might differ from customer to customer and lead to specific and different degradation effects. The at least first spare optical element might thus be different from optical system to optical system.

The method further comprises working the at least one first spare optical element prior to inserting same into the projection objective.

Provided that the nature of the first spare optical element allows a working, for example a machining, in particular providing at least one surface of the at least one first spare optical element with an aspherical or even non-rotational symmetric surface shape, this measure has the advantage that the first spare optical element can provide a desired correction of the image quality, for example in order to compensate for differences in the optical effect of the first spare optical element versus the first optical element which is replaced by the first spare optical element. The working of the first spare optical element can also be used to alter the image quality of the projection objective compared to the image quality of the projection objective in its original state.

In another preferred embodiment, the at least one first spare optical element is the first optical element after removal from the projection objective and subsequent working.

This measure has the advantage of further reducing the costs of the repairing of the projection objective. Taking into consideration that the optical elements of the projection objective are very expensive in terms of manufacturing, the re-use of the first optical element after removal from the projection objective and subsequent working, e.g. in order to remove material defects from the optical element or its coating, can significantly contribute to a cost reduction in the repairing of the projection objective.

In order to reduce the downtime, e.g. in case that the first optical element is re-used as the first spare optical element after re-working same, it is further preferred, if the at least one first spare optical element is chosen from a pool of first optical elements, which have been removed from other projection objectives and which have been worked according to one or more of the above-mentioned working processes. For example, a plurality of first optical elements which have been removed from a plurality of projection objectives can be re-worked and kept in supply and exchanged in a subset of projection objectives.

Due to the working of the at least one first optical element, a thickness of the at least one first optical element is reduced compared with the thickness of the at least one first optimal element in the original state thereof.

The reduced thickness of the re-worked first optical element may lead to a significant alteration of the optical effect of the first optical element when re-inserted in the projection objective compared with the original state of the first optical element. But, according to the present disclosure this difference can be compensated for, for example by providing the at least one first optical element prior to its insertion as first spare optical element into the projection objective with an aspherical or even non-rotational symmetric surface shape suited for correcting the difference, and/or by re-positioning all or some of the optical elements ("set-up").

While it has been previously described that the first spare optical element can be the degraded first optical element after removal from the projection objective or another projection objective and re-working same, it is also possible that the at least one first spare optical element is an essentially identical optical element of the same type as the removed first optical element in the original state thereof.

In a further preferred embodiment, the step of adjusting an image quality comprises the steps of measuring an image quality and adjusting the image quality by a movement and/or deformation of at least one further optical element. This at least one further optical element can be the spare optical element itself.

There is also disclosed a method comprising selecting at least one second optical element from the plurality of optical elements, removing the at least one second optical element from the projection objective and inserting at least one second spare optical element into the projection objective at a location of the second optical element, wherein the at least one second spare optical element is worked and / or chosen in dependence on the difference between the actual image quality obtained by a measurement and the desired image quality.

The at least one second spare optical element is advantageous in case that the image quality of the projection objective, after replacement of the first optical element by the first spare optical element cannot be fully adjusted to the desired image quality, while the second spare optical element can provide further degrees of freedom of correction of the projection objective. Further, while the first spare optical element may be worked and / or chosen, for example provided with an aspherical or even non-rotational symmetrical correction surface in order to be able to adjust a desired image quality or chosen with a desired index distribution in case the second spare optical element is of refractive type, it can happen that the first spare optical element does not allow such a working process and/or such a working process is not in position to result in a desired image quality. For example, the first spare optical element may suffer from inhomogeneity errors of the material leading to deviations from the image quality. In such instances, the second spare optical element can be designed to allow machining of its surfaces and/or can be more easily chosen with a desired index distribution and can be used as the correction element for adjusting a desired image quality. This is especially advantageous if the first spare optical element is the last optical element next to the image plane, for example in projection objectives of immersion type or the last but one optical element in projection objectives of double immersion type.

Prior to inserting the second spare optical element into the projection objective, the at least one second spare optical element is worked.

The working of the at least one second spare optical element comprises altering the material thickness of the at least one second spare optical element.

Altering the material thickness of the at least one second spare optical element has proved to be a suitable correction mechanism in case that the first spare optical element has a reduced thickness compared with the first optical element in its original state.

The working of the at least one second spare optical element may comprise providing at least one surface of the at least one second spare optical element with an aspherical or even non-rotational symmetric surface shape.

By virtue of providing the at least one second spare optical element with an aspherical or even non-rotational symmetric surface shape, an improved correction capability can be achieved in order to be able to adjust the image quality as desired.

In a further preferred embodiment, the at least one second optical element previously removed is the at least one second spare optical element after working same. A similar embodiment has been described above with respect to the first spare optical element.

In a further preferred embodiment, the method further comprises, after inserting the at least one first spare optical element, and prior to working the at least one second spare optical element, measuring the image quality of the projection objective in the field, and calculating a correction profile for the at least one second spare optical element in dependence on the measured image quality, and working the at least one second spare optical element in dependence on the calculated correction profile.

This "two-step" process is particularly advantageous, if the first spare optical element is sensitive to deformations when being inserted into the projection objective. By inserting the first spare optical element into the projection objective, deformations of the first spare optical element can occur which cannot be pre-simulated prior to the insertion of the first spare optical element. In this case, it is advantageous to first insert the first spare optical element into the projection objective, to measure the image quality of the projection objective, and then to calculate a correction profile required for the second spare optical element in order to obtain the desired image quality. Thus, image defects caused by the insertion process of the first spare optical element are taken into account when calculating the correction profile for the second spare optical element. After working the second spare optical element accordingly, the second spare optical element is inserted into the projection objective.

In an alternative embodiment, the at least one second spare optical element is worked in dependence on the desired image quality based on a simulation of the optical effect of the first spare optical element, and thereafter the first and second spare optical elements are inserted into the projection objective.

This "one-step" process is advantageous in terms of a reduced time consumption and can be used in particular in case that the first spare optical element is not or less sensitive to deformation when being inserted into the projection objective.

In another preferred embodiment, the adjusting of the image quality comprises at least approximately maintaining the image quality prior to the degradation of the optical system.

The advantage of this measure is that the fingerprint of the projection objective is at least approximately not altered by the revision/repairing process.

It can also be preferred, if the adjusting of the image quality comprises altering the image quality compared to the image quality prior to the degradation of the optical system, for example by increasing and decreasing at least one specific image defect in accordance with the operational requirement in use of the projection objective.

As already mentioned at the outset, it can be desired by the customer under certain circumstances to increase an image defect, like coma, for certain lithography exposure processes. In a preferred embodiment several spare parts may be provided with individual correction surfaces to establish several lithography apparatuses with essentially identical optical performance.

Such operational requirements may comprise an illumination setting of the projection exposure apparatus and/or the object to be imaged by the projection objective.

The adjusting of the image quality comprises adjusting the position and/or shape of at least one of the optical elements of the plurality of optical elements.

The adjusting of the position of one or more of the optical elements can include an x-, y-, and/or z-translational and/or rotational positioning by means of suitable actuators or manipulators, and in case of an active lens element, which is deformable by suited actuators or manipulators, the adjusting can include adjusting the shape of such an optical element. Alternatively or additionally the manipulators of the active lens element can change the index distribution of the optical element in case the optical element is of refractive type. This can be realized by heating and/or cooling, squeezing or bending the refractive element.

In a further preferred embodiment, the at least one first optical element is the last lens element next to the image plane where, in case of a projection objective of immersion type, the immersion liquid does not count as an optical element.

In a further preferred embodiment, the at least one first optical element is the last but one lens element in a projection objective of double immersion type.

As already mentioned above, in particular the last lens element of a projection objective of immerson type is often subject to degradation, for example due to a contact of the lens element with an immersion liquid or by scratching the coating. The last optical element may be a relatively thick lens with large curvature on the entrance side and preferably a plane surface next to the image plane. This lens may also suffer from degradations due to the large power concentration close to the image.

In another preferred embodiment, the at least one second optical element is an element without refractive power, in particular a plane-parallel plate where, in case of a projection objective of double immersion type the at least one second optical element is a plane-parallel plate which is located in between the two immersion liquids.

The use of a plane-parallel plate as the second optical element to be selected as correction element has the advantage of its better commandability in terms of providing such an element with a correction surface in comparison with optical elements having a concave and/or convex surface.

The at least one second optical element is preferably arranged at a location near a field plane or near a pupil plane of the projection objective. A plane-parallel plate in a location near a field plane is particularly sensitive to field-dependent image defects and thus capable of correcting such image defects, and a plane-parallel plate positioned near a pupil plane is particularly capable of correcting image defects which are at least approximately constant over the field.

Within the scope of the invention, it is particularly preferred, if there are two second optical elements which can be selected as correction elements, one of the second optical elements being arranged near a field plane and the other one being arranged near a pupil plane of the projection objective.

Further advantages and features will become apparent from the following description and the accompanying drawings.

It is to be understood that the above-mentioned features and those still to be explained below are not only applicable in the combinations given, but also in other combinations or in isolation.

Exemplary embodiments, which include embodiments of the invention, are shown in the drawings and will be described hereinafter with reference thereto, in which:
- Fig. 1: schematically shows a lithography exposure apparatus including a projection objective;
- Fig. 2: shows a flow chart of a first embodiment of a method for revising/repairing the projection objective in Fig. 1;
- Fig. 3: shows a flow chart of a second embodiment of a method for revising/repairing the projection objective in Fig. 1;
- Fig. 4: shows a diagram for illustrating the effect of different correction processes after exchange of an optical element in a projection objective;
- Fig. 5: shows a design of a catadioptric projection objective of immersion type;
- Fig. 6: shows another design of a catadiotric projection objective of immersion type; and
- Fig. 7: shows a catadioptric projection objective of double immersion type.

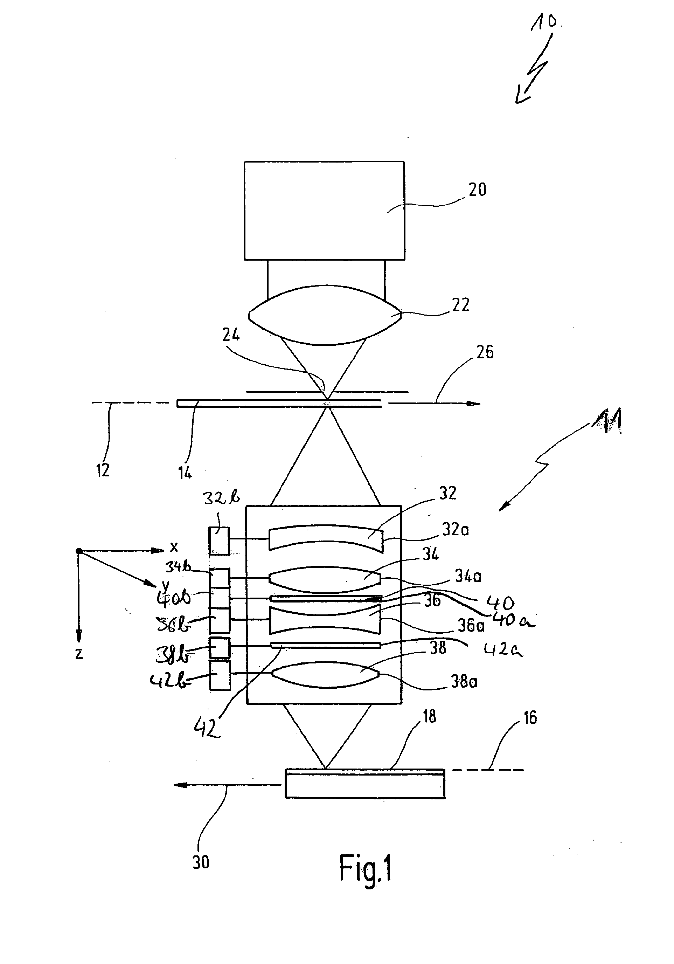

Fig. 1 schematically shows a lithography projection exposure apparatus generally labeled with reference numeral 10. The projection exposure apparatus 10 is used in a microlithographical process of manufacturing semiconductor devices, for example.

The projection exposure apparatus 10 comprises a projection objective 11 which images an object (reticle) 14 which is arranged in an object plane 12 of the projection objective 11 onto a substrate 18 (wafer) arranged in an image plane 16 or the projection objective 11. The light for imaging the object 14 onto the substrate 16 is produced by a light source 20 (for example a laser) and is directed onto the object 14 by means of an illumination optics 22 from which the light enters into the projection objective 11.

The imaging of the object 14 onto the substrate 18 is performed in a so-called scan-process in which the light from the illumination optics 22 is directed through a scanning slot 24, a width of which is less than the dimension of the object 14 onto the object. The object 14 is displaced in a scan direction 26 in order to progressively project the whole object 14 onto the substrate 18, while the substrate 18 arranged on a stage 28 is displaced in a direction 30 opposite to the scan direction 26.

The projection objective 11 comprises a plurality of optical elements arranged in direction of the propagation of the light (z-direction) through the projection objective 11. In the embodiment shown, the projection objective 11 comprises six optical elements, four of which are optical elements having a refractive power, namely optical elements 32, 34, 36 and 38. The remaining two optical elements 40 and 42 are optical elements without refractive power, and are plane-parallel plates in the embodiment shown.

It is to be understood that the number of optical elements can be more or less than six. Further, the shapes of the optical elements are not restricted to the shapes shown. Typically more than six lenses and at least one mirror are used in immersion lithography. The number and shape of optical elements is determined by the requirements of the imaging performance. Typically, a wavefront aberration of less than 1 nm rms is required over an imaging field of 10 x 30 mm, roughly, at a wavelength of 248 nm or 193 nm and a numerical aperture well above 0.9, up to numerical apertures in the order of NA = 1.3, which became possible by immersion liquids like water.

The optical elements 32 through 42 are held in mounts 32a through 42a so as to be capable of being adjustable in position via the mounts 32a through 42a.

Some of the optical elements 32 through 42, in the present embodiment all optical elements 32 through 42, are assigned actuators or manipulators 32b through 42b in order to adjust the position of each optical element 32 through 42. The actuators or manipulators can be capable of positioning the optical elements 32 through 42 in x-, y- and/or z-direction according to the coordinate system shown in Fig. 1. It is to be understood that not only translational movements are possible, but also rotational movements about the x-, y- and/or z-axis. Further, some of the optical elements 32 through 42 may be configured as actively deformable elements and/or they are capable to change their index distribution in case they are of refractive type, and some of the actuators 32b through 42b may be designed to be capable of deforming the corresponding optical elements 32 through 42 and/or change their index distribution in case they are of refractive type.

After a certain lifetime of the projection objective 11, one or more of the optical elements 32 through 42, in particular the optical elements 32 through 38 having refractive power may be degraded.

For example, in case that the projection objective 11 is used in immersion lithography, the last optical element 38 is in contact to an immersion liquid (not shown) which may be aggressive to the coating and bulk material of the optical element 38. After a certain lifetime, the optical element 38 can be degraded in an extent that the projection objective 11 has to be repaired.

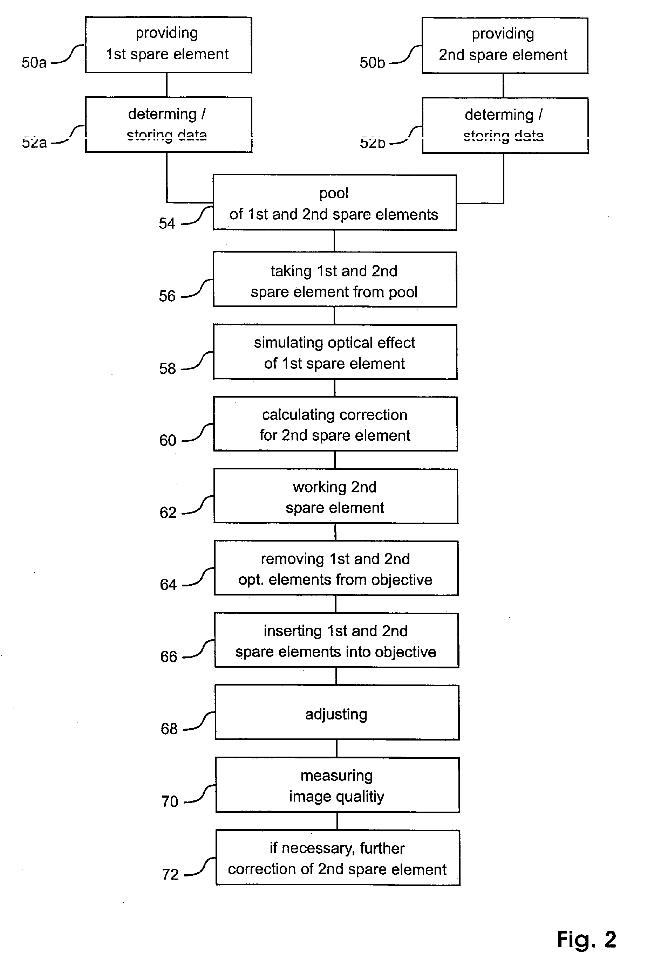

With reference to Fig. 2, an embodiment of a method for repairing the projection objective 11 will be described. In the following description, the optical element 38 is referred to as the first optical element.

The method to be described below can be performed in the field, i.e. at the customer's location and without the need of exchanging all of the optical elements 32 through 42, but only requires the exchange of two of the optical elements 32 through 42. These optical elements are the degraded first optical element 38 and one of the optical elements 40 and 42 which is referred hereinafter to as the second optical element.

The method for repairing the projection objective 11 comprises at 50a providing at least one, preferably a plurality of first spare optical elements which can be used as replacement for the first optical element 38. Accordingly, the first spare optical elements are designed and manufactured in accordance with the first optical element 38 which is to be replaced after degradation. At 52a, all data relevant to the exchange of the first optical element 38 by the first spare optical elements are determined and stored.

At 50b and 52b, at least one, preferably a plurality of second spare optical elements are provided, and their data relevant to the exchange process are determined and stored. In the following description, it is assumed that the second spare optical element is used as replacement of the second optical element 40.

At 54, all first and second spare optical elements are collected in a pool in order to reduce the time of response when an actual repairing process is to be carried out in the field.

If repairing is necessary, a first and a second spare optical element are taken from the pool as indicated with reference numeral 56.

Next, at 58, the difference of the optical effect of the first spare optical element compared with the first optical element 38 in the original state of the projection objective 11 is simulated. It is to be noted that even though the first spare optical element is designed and manufactured in accordance with the first optical element 38 to be replaced, it is not possible to provide the first spare optical element with characteristics which are absolutely identical with the characteristics of the first optical element 38 in its original state. Therefore, there will be some difference in the optical effect between the first spare optical element and the first optical element in its original state.

Based on the result of the simulating step at 58, a correction surface shape is calculated which the second spare optical element should have in order to correct or compensate the difference in the optical effects of the first spare optical element versus the first optical element 38.

The correction surface shape usually is an aspherical or even non-rotational symmetric shape.

At 62, the second spare optical element is worked, for example machined in order to provide the second spare optical element with the correction surface shape as calculated in step 60.

It is to be noted that a correction surface may also be provided on the first spare optical element, if the first spare optical element allows such a working, in particular a machining of the first spare optical element. However, in some instances, in particular if the first spare optical element is made from a material which is difficult to be worked, in particular to be machined, as it is the case for calcium fluoride, a working process is not possible or at least not to an extent which would be necessary for correcting image defects caused by the difference in the optical effect between the first spare optical element and the first optical element 38 to be replaced.

Next, the first spare optical element and the second spare optical element are transported to the customer.

At 64, the first optical element 38 and the second optical element 40 are removed from the projection objective 11.

At 66, the first and second spare optical elements are inserted into the projection objective, at the location where the respective optical elements were arranged prior to their removal from the projection objective 11.

At 68, the image quality of the projection objective 11 is adjusted, in particular by using the actuators or manipulators 32b through 42b in order to adjust a desired image quality.

At 70, the actual image quality is measured, whereafter another adjusting step can follow. If the desired image quality cannot be adjusted solely by positioning and/or deforming all or some of the optical elements 32 through 42, then another correction of the second spare optical element can be performed, wherein it is possible to remove the previously inserted second spare optical element from the projection objective 11 again and to correct it or to provide another second spare optical element previously worked in accordance with the desired image quality as replacement for the actual second spare optical element.

The method for repairing the projection objective 11 described before is a "one-step" process.

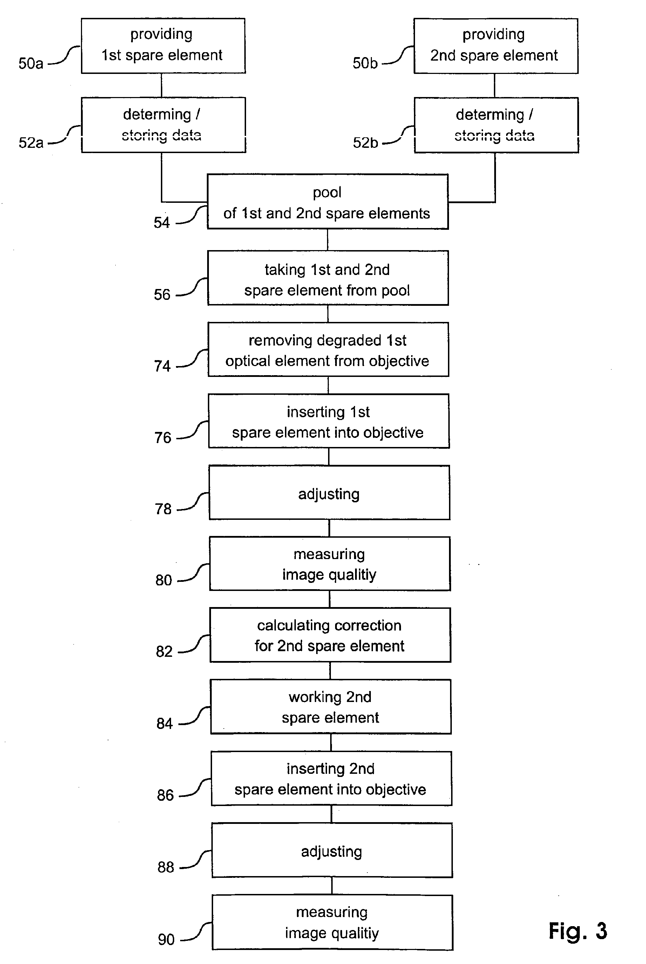

With reference to Fig. 3, a "two-step" repairing process will be described in the following.

Steps 50a, 50b, 52a, 52b, 54 and 56 are identical with the corresponding steps of the method described before. While step 58 in Fig. 2 has been omitted in Fig. 3, step 58 can also be used in the method according to Fig. 3.

The difference between the method according to Fig. 3 and the method according to Fig. 2 is that the correction to be provided by the second spare optical element is not calculated prior to, but after the insertion of the first spare Optical element into the projection objective 11.

Therefore, at 74, the degraded first optical element (optical element 38) is removed from the projection objective 11. At 76, the first spare optical element is inserted into the projection objective 11 at the location where the first optical element (optical element 38) was arranged in the original state.

Next, the first spare optical element is adjusted in position (at 78), and the image quality is measured (at 80).

At 82, the required correction to be provided by the second spare optical element is calculated on the basis of the results of the previous measuring step.

The advantage of this procedure is that in case that the first spare optical element was deformed when being inserted into the projection objective 11, such deformations which contribute to image defects of the projection objective 11, are involved in the calculation of the required correction to be provided by the second spare optical element. Furthermore, while the calculation step 60 in the method according to Fig. 2 is only based on the simulation of the difference of the optical effect of the first spare optical element versus the first optical element to be replaced, the calculation step 82 also includes the optical performance of the whole projection objective 11, i.e. of the optical effect of all optical elements 32 through 42. Especially, differences in the refractive index distribution of the first spare optical element may be distracting, such that the simulation of the optical performance of the optical system with the first spare optical element might be impossible with the required accuracy. Therefore it might be advantageous first to measure after insertion of the first spare optical element the optical performance and second to calculate a correction surface of a second spare element.

At 84, the second spare optical element is worked on the basis of the calculation step 82, in particular machined, in order to provide the second spare optical element with a correction surface shape which usually will be an aspherical or even non-rotational symmetric surface shape.

At 86, the second spare optical element 11 inserted into the projection objective 11, and the projection objective 11 is adjusted (at 88) and the image quality is measured again at 90. Normally, the method according to Fig. 3 does not require a repetition of the correction of the second spare optical elements, because the calculation step 82 has been performed after insertion of the first spare optical element into the projection objective 11.

It is to be noted that the adjusting of the image quality of the projection objective 11 may not only directed to the purpose of maintaining the image quality of the projection objective 11 prior to the degradation of one or more of the optical elements 32 through 42, but can be directed to an altering of the image quality. Depending on the operational requirement in use of the projection objective 11, it can be desired by the customer to increase and/or decrease certain image defects, for example to introduce or increase coma, which may be useful for a specific illumination setting or a specific object (reticle) to be imaged by the projection objective 11.

In the following, modifications of the methods according to Figs. 2 and 3 will be described.

As already described with respect to Figs. 2 and 3, it is preferred, if a plurality of first and second spare optical elements are kept in supply in a pool as shown with reference numeral 54 in Figs. 2 and 3. Further, it has been described above that the first and second spare optical elements kept in supply in the pool are freshly manufactured elements. However, it is also conceivable to build up at least the pool of first spare optical elements from those optical elements which have been removed from existing projection objectives which have been re-worked for re-use in the same or other projection objectives.

In order to be more precise, the following embodiment of a repairing process can be applied.

Starting from the projection objective 11 in Fig. 1, the degraded first optical element 38 is removed from the projection objective 11.

Next, the first optical element 38 is re-worked in order to remove coating and/or material defects from the optical element. Such a re-working can be done by machining the first optical element 38 after removal from the projection objective 11.

Normally, such a working or re-working of the first optical element 38 leads to a significant reduction of the thickness, in particular in the center of the first optical element. Experiments have shown that a thickness reduction in the range of several µm to more than 100 µm can occur in such a re-working procedure when material defects are removed.

The significant reduction of the thickness of the re-worked first optical element 38 when re-used as the first spare optical element in the same projection objective 11 or another projection objective of the same kind as the projection objective 11 will lead to a significant alteration of the image quality of the projection objective.

Therefore, when the re-worked first optical element is used as the first spare optical element in the projection objective 11 or another projection objective, measures for correcting image defects caused by the significant material thickness reduction are required.

The following correction processes and combinations thereof can be performed.

One of the correction processes consists in using the actuators or manipulators 32b through 42b in order to re-adjust the position of the optical elements 32 through 42, preferably using all degrees of freedom of movement of the optical elements 32 through 42 including translational and rotational degrees of freedom of movement, and if provided deformations.

Another correction process consists in working the re-worked first optical element reduced in thickness such that it is provided with an aspherical surface shape.

Still another correction process consists in selecting a second optical element of the plurality of optical elements 32 through 42, for example the optical element 40 and/or the optical element 42 and providing same with an aspherical or even non-rotational symmetric correction surface.

Alternatively or in addition to the previous correction process, the second optical element which has been provided with an aspherical or even non-rotational symmetric correction surface, or another optical element of the plurality of optical elements 32 through 42 is worked such that the thickness thereof is altered, for example reduced in order to compensate image defects caused by the thickness reduction of the first optical element 38.

Preferably, a combination of the above-mentioned correction processes is performed, simultaneously or step by step.

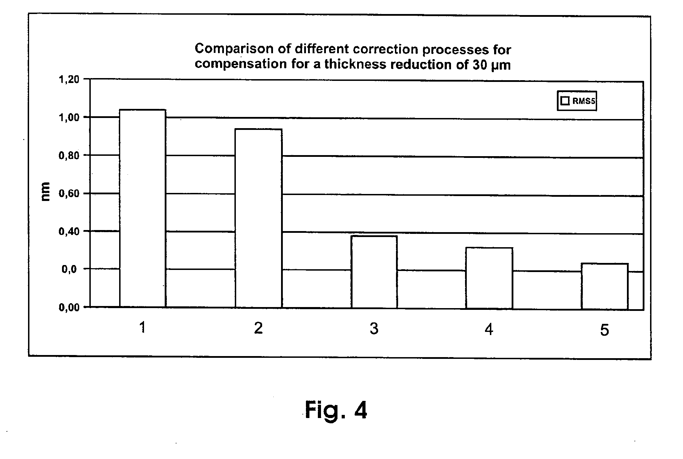

Fig. 4 shows a diagram in which columns indicate residual image defects in dependence of the correction process applied. The first optical element 38 has been worked such that its thickness was reduced by about 30 µm. Without any correction for compensating for the thickness reduction, the maximum of the RMS Z5 over the field was more than 110 nm.

The first column in Fig. 4 shows the residual RMS Z5 after using the first correction process above using a re-positioning of the optical elements 32 through 42. Hence RMS Z5 has been reduced by one order of magnitude.

The second column shows the residual RMS Z5 after using the correction process used in the first column and additionally using a thickness variation of a second optical element.

The third column shows the residual RMS Z5 after a correction process using the set-up (first column) and additional using and aspherical correction surface on the first optical element 38 itself.

The fourth column shows the residual RMS Z5 after using a correction process using the set-up (first column) and additionally using an aspherical correction surface on the second optical element.

Finally, the fifth column shows the residual RMS Z5 using a combination of all correction processes according to columns 1 through 4. The final wavefront error Z5 is well below an acceptable limit of 0.3 nm RMS.

Fig. 4 shows that it is possible to compensate for image defects caused by a significant thickness reduction of the re-worked and re-inserted first optical element without necessitating an exchange of more than two optical elements in the projection objective 11.

Further, with respect to the afore-going embodiments, it is to be noted that two second optical elements can be provided in the projection objective 11 which can be selected as correction elements after an exchange of an optical element of the optical elements 32 through 38 having refractive power.

In particular, one of the second optical elements 40 can be arranged at a location near a field plane, and the other of the second optical elements 40, 42 should be arranged at a location near a pupil plane of the projection objective 11 so that it is possible to compensate image defects having a field dependence as well as correcting image defects which are substantially constant over the field.

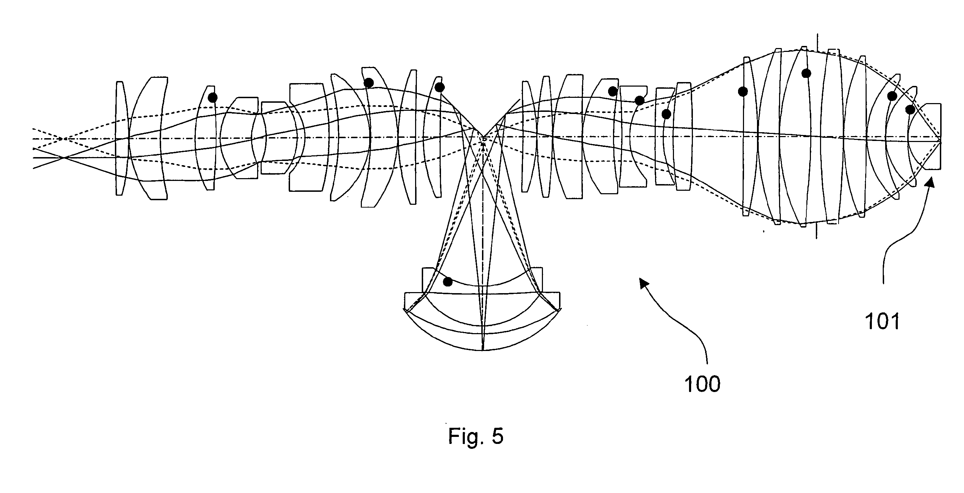

Fig. 5 shows a design of a catadioptric projection objective of immersion type 100 where the optical element 101 is referred to be the first optical element. In particular the optical element 101 is made of CaF2, BaF2, LiF, LUAG or Spinell or it is mixed crystal of those. The lenses and / or mirrors which are marked with a dot are those which are aspherical.

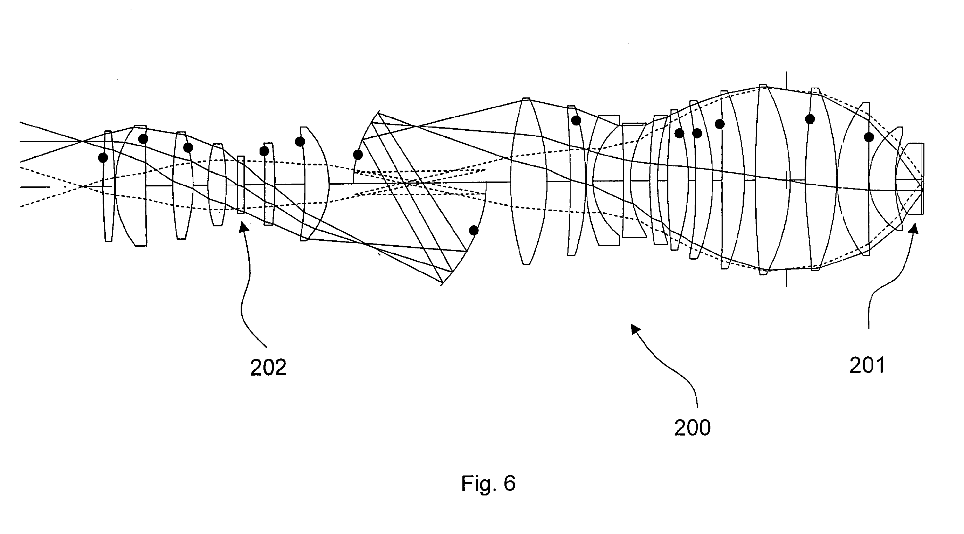

Fig. 6 shows another design of a catadioptric projection objective of immersion type 200 where the optical element 201 is referred to be the first optical element and the optical element 202 is a plane-parallel plate which is referred to be the second optical element. The second optical element is situated in a pupil plane of the projection objective. The lenses and / or mirrors which are marked with a dot are those which are aspherical.

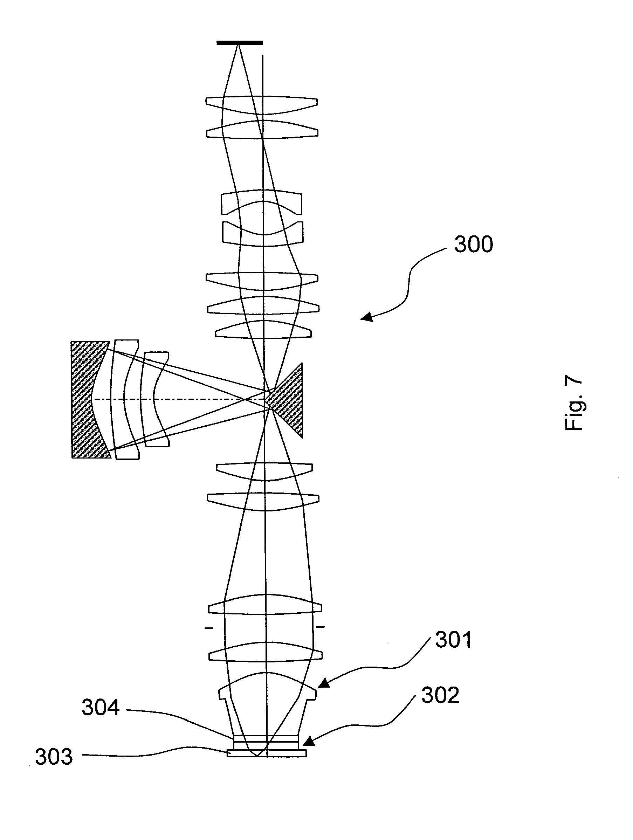

Fig. 7 shows a projection objective of double immersion type 300 where the optical element 301 is referred to be the first optical element and the optical element 302 is a plane-parallel plate which is referred to be the second optical element. The second optical element is situated near a field plane of the projection objective. The two immersion liquids are 303 and 304. Even though there are no dots as in the last two figures there may be aspherical lenses and / or mirrors in this projection objective as well.

## Claims

1. A method for revising or repairing a projection objective (11) of a lithography projection exposure apparatus in the field, the projection objective (11) comprising a plurality of optical elements (32, 34, 36, 38, 40, 42a) between an object plane (12) and an image plane (16), the plurality of optical elements (32, 34, 36, 38, 40, 42a) comprising at least one first optical element (38) having a refractive power, the method comprising, without exchanging all of the optical elements (32, 34, 36, 38, 40, 42a),
removing the at least one first optical element (38) from the projection objective (11) in the field,
inserting at least one first spare optical element into the projection objective (11) at the location of the at least one first optical element (38), wherein due to working the at least one first spare optical element prior to inserting same into the projection objective, said first spare optical element has a thickness which is reduced compared with the thickness of the at least one first optical element (38),
adjusting an image quality of the projection objective (11) to a desired quality, in order to correct image defects caused by the reduced thickness of the at least one first spare optical element, by
selecting at least one second optical element (40) from the plurality of optical elements (32, 34, 36, 38, 40, 42a), removing the at least one second optical element (40) from the projection objective (11) and inserting at least one second spare optical element into the projection objective (11) at the location of the second optical element (40), wherein prior to inserting the second spare optical element into the projection objective (11), the at least one second spare optical element is worked, wherein the working of the at least one second spare optical element comprises altering the material thickness of the at least one second spare optical element, and/or wherein the working comprises providing at least one surface of the at least one second spare optical element with an aspherical or even non-rotational symmetric surface shape.

2. The method of claim 1, wherein the working comprises machining the at least one first spare optical element.

3. The method of claim 1 or 2, wherein the at least one first spare optical element is the first optical element (38) after removal from the projection objective (11) and subsequent working.

4. The method of anyone of claims 1 through 3, wherein the at least one first spare optical element is an essentially identical optical element of the same type as the removed first optical element (38) in the original state thereof.

5. The method of anyone of claims 1 through 4, wherein the step of adjusting an image quality comprises the steps of measuring an image quality and adjusting the image quality by movement and/or deformation of at least one further optical element and/or changing the index distribution of the further optical element in case this further optical element is of refractive type.

6. The method of anyone of claims 1 through 5, wherein the projection objective (11) is of immersion type or of double immersion type.

7. The method of anyone of claims 1 through 6, wherein the first optical element (38) is one of BaF2, LiF, BaLiF3, LUAG or Spinell.

8. The method of anyone of claims 1 through 7, wherein the at least one second spare optical element is designed in dependence on the difference between the actual image quality obtained by a measurement and the desired image quality.

9. The method of anyone of claims 1 through 8, wherein the previously removed at least one second optical element (40) is the at least one second spare optical element.

10. The method of anyone of claims 1 through 9, further comprising, after inserting the at least one first spare optical element, and prior to working the at least one second spare optical element, measuring the image quality of the projection objective (11) in the field, and calculating a correction profile for the at least one second spare optical element in dependence on the measured image quality, and working the at least one second spare optical element in dependence on the calculated correction profile.

11. The method of anyone of claims 1 through 10, wherein the at least one second spare optical element is worked in dependence on the desired image quality based on a simulation of the optical effect of the first spare optical element, and thereafter the first and second spare optical elements are inserted into the projection objective (11).

12. The method of anyone of claims 1 through 11, wherein the at least one second optical element (40) is one of BaF2, LiF, BaLiF3, LUAG or Spinell.

13. The method of anyone of claims 1 through 12, wherein the adjusting of the image quality comprises at least approximately maintaining the image quality prior to the degradation of the optical system.

14. The method of anyone of claims 1 through 13, wherein the adjusting of the image quality comprises altering the image quality compared to the image quality prior to the degradation of the optical system.

15. The method of claim 14, wherein the altering of the image quality comprises at least one of increasing and decreasing at least one specific image defect in accordance with the operational requirement in use of the projection objective (11).

16. The method of claim 15, wherein the operational requirement comprise at least one of an illumination setting of the projection exposure apparatus and the kind of object to be imaged by the projection objective (11).

17. The method of anyone of claims 1 through 16, wherein the at least one first optical element (38) is the lens element closest to the image plane (16).

18. The method of anyone of claims 1 through 16, wherein the at least one second optical element is the lens element closest to the image plane (16).

19. The method of anyone of claims 1 through 18, wherein the at least one second optical element (40) is an element without refractive power, in particular a plane-parallel plate.

## Patentansprüche

1. Verfahren zur Revidierung bzw. Reparatur eines Projektionsobjektivs (11) einer lithografischen Projektionsbelichtungsvorrichtung im Feld, wobei das Projektionsobjektiv (11) eine Mehrzahl von optischen Elementen (32, 34, 36, 38, 40, 42a) zwischen einer Objektebene (12) und Bildebene (16) aufweist, die Mehrzahl von optischen Elementen (32, 34, 36, 38, 40, 42a) mindestens ein erstes optisches Element (38) mit einer Brechungskraft aufweist, und das Verfahren ohne Austauschen aller optischen Elemente (32, 34, 36, 38, 40, 42a) aufweist:
Entfernen des mindestens einen ersten optischen Elements (38) aus dem Projektionsobjektiv (11) im Feld,
Einfügen mindestens eines ersten optischen Ersatzelements in das Projektionsobjektiv (11) an der Stelle des mindestens einen ersten optischen Elements (38), wobei aufgrund des Bearbeitens des mindestens einen ersten optischen Ersatzelements vor dem Einfügen desselben in das Projektionsobjektiv das erste optische Ersatzelement eine Dicke aufweist, die gegenüber der Dicke des mindestens einen ersten optischen Elements (38) reduziert ist,
Einstellen einer Bildqualität des Projektionsobjektivs (11) auf eine gewünschte Qualität, um Bildfehler zu korrigieren, die durch die reduzierte Dicke des mindestens einen ersten optischen Ersatzelements verursacht werden, durch
Auswählen mindestens eines zweiten optischen Elements (40) aus der Mehrzahl von optischen Elementen (32, 34, 36, 38, 40, 42a), Entfernen des mindestens einen zweiten optischen Elements (40) aus dem Projektionsobjektiv (11) und Einfügen mindestens eines zweiten optischen Ersatzelements in das Projektionsobjektiv (11) an der Stelle des zweiten optischen Elements (40), wobei das mindestens eine zweite optische Ersatzelement vor dem Einfügen des zweiten optischen Ersatzelements in das Projektionsobjektiv (11) bearbeitet wird, wobei das Bearbeiten des mindestens einen zweiten optischen Ersatzelements ein Ändern der Materialdicke des mindestens einen zweiten optischen Ersatzelements aufweist, und/oder wobei das Bearbeiten ein Bereitstellen mindestens einer Fläche des mindestens einen zweiten optischen Ersatzelements mit einer asphärischen oder ebenen rotationsfreien symmetrischen Flächenform aufweist.

2. Verfahren nach Anspruch 1, wobei das Bearbeiten ein maschinelles Bearbeiten des mindestens einen ersten optischen Ersatzelements aufweist.

3. Verfahren nach Anspruch 1 oder 2, wobei das mindestens eine erste optische Ersatzelement das erste optische Element (38) nach der Entfernung aus dem Projektionsobjektiv (11) und der anschließenden Bearbeitung ist.

4. Verfahren nach einem der Ansprüche 1 bis 3, wobei das mindestens eine erste optische Ersatzelement ein im Wesentlichen identisches optisches Element vom gleichen Typ wie das entfernte erste optische Element (38) im Originalzustand davon ist.

5. Verfahren nach einem der Ansprüche 1 bis 4, wobei der Schritt des Einstellens der Bildqualität die Schritte des Messens einer Bildqualität und Einstellens der Bildqualität durch Bewegung und/oder Verformung mindestens eines weiteren optischen Elements und/oder Änderns der Indexverteilung des weiteren optischen Elements aufweist, falls dieses weitere optische Element vom Brechungstyp ist.

6. Verfahren nach einem der Ansprüche 1 bis 5, wobei das Projektionsobjektiv (11) vom Immersionstyp oder vom Doppelimmersionstyp ist.

7. Verfahren nach einem der Ansprüche 1 bis 6, wobei das erste optische Element (38) eines von BaF2, LiF, BaLiF3, LUAG oder Spinell ist.

8. Verfahren nach einem der Ansprüche 1 bis 7, wobei das mindestens eine zweite optische Ersatzelement in Abhängigkeit von der Differenz zwischen der tatsächlichen Bildqualität, die durch eine Messung erhalten wird, und der gewünschten Bildqualität ausgelegt wird.

9. Verfahren nach einem der Ansprüche 1 bis 8, wobei das vorher entfernte mindestens eine zweite optische Element (40) das mindestens eine zweite optische Ersatzelement ist.

10. Verfahren nach einem der Ansprüche 1 bis 9, ferner aufweisend nach dem Einfügen des mindestens einen ersten optischen Ersatzelements und vor dem Bearbeiten des mindestens einen zweiten optischen Ersatzelements ein Messen der Bildqualität des Projektionsobjektivs (11) im Feld und Berechnen eines Korrekturprofils für das mindestens eine zweite optische Ersatzelement in Abhängigkeit von der gemessenen Bildqualität und Bearbeiten des mindestens einen zweiten optischen Ersatzelements in Abhängigkeit vom berechneten Korrekturprofil.

11. Verfahren nach einem der Ansprüche 1 bis 10, wobei das mindestens eine zweite optische Ersatzelement in Abhängigkeit von der gewünschten Bildqualität basierend auf einer Simulation des optischen Effekts des ersten optischen Ersatzelements bearbeitet wird, und danach die ersten und zweiten optischen Ersatzelemente in das Projektionsobjektiv (11) eingefügt werden.

12. Verfahren nach einem der Ansprüche 1 bis 11, wobei das mindestens eine zweite optische Element (40) eines von BaF2, LiF, BaLiF3, LUAG oder Spinell ist.

13. Verfahren nach einem der Ansprüche 1 bis 12, wobei das Einstellen der Bildqualität ein mindestens ungefähres Aufrechterhalten der Bildqualität vor der Verschlechterung des optischen Systems aufweist.

14. Verfahren nach einem der Ansprüche 1 bis 13, wobei das Einstellen der Bildqualität ein Ändern der Bildqualität gegenüber der Bildqualität vor der Verschlechterung des optischen Systems aufweist.

15. Verfahren nach Anspruch 14, wobei das Ändern der Bildqualität mindestens eines von einem Vergrößern oder Verkleinern mindestens eines spezifischen Bildfehlers gemäß der Betriebsanforderung in Verwendung des Projektionsobjektivs (11) aufweist.

16. Verfahren nach Anspruch 15, wobei die Betriebsanforderung mindestens eine von einer Beleuchtungseinstellung der Projektionsbelichtungsvorrichtung und der Art des durch das Projektionsobjektiv (11) abzubildenden Objekts ist.

17. Verfahren nach einem der Ansprüche 1 bis 16, wobei das mindestens eine erste optische Element (38) das Linsenelement am nächsten zur Bildebene (16) ist.

18. Verfahren nach einem der Ansprüche 1 bis 16, wobei das mindestens eine zweite optische Element das Linsenelement am nächsten zur Bildebene (16) ist.

19. Verfahren nach einem der Ansprüche 1 bis 18, wobei das mindestens eine zweite optische Element (40) ein Element ohne Brechungskraft, insbesondere eine planparallele Platte ist.

## Revendications

1. Procédé de révision ou réparation d'un objectif de projection (11) d'un appareil d'exposition par projection lithographique sur le terrain, l'objectif de projection (11) comprenant une pluralité d'éléments optiques (32, 34, 36, 38, 40, 42a) entre un plan objet (12) et un plan image (16), la pluralité d'éléments optiques (32, 34, 36, 38, 40, 42a) comprenant au moins un premier élément optique (38) ayant une puissance optique, le procédé comprenant, sans échanger tous les éléments optiques (32, 34, 36, 38, 40, 42a),
le retrait de l'au moins un premier élément optique (38) de l'objectif de projection (11) sur le terrain,
l'insertion d'au moins un premier élément optique de rechange dans l'objectif de projection (11) à l'emplacement de l'au moins un premier élément optique (38), dans lequel en raison du travail de l'au moins un premier élément optique de rechange avant son insertion dans l'objectif de projection, ledit premier élément optique de rechange a une épaisseur qui est réduite par rapport à l'épaisseur de l'au moins un premier élément optique (38),
le réglage d'une qualité d'image de l'objectif de projection (11) à une qualité souhaitée, afin de corriger des défauts d'image provoqués par l'épaisseur réduite de l'au moins un premier élément optique de rechange, par
sélection d'au moins un deuxième élément optique (40) parmi la pluralité d'éléments optiques (32, 34, 36, 38, 40, 42a), retrait de l'au moins un deuxième élément optique (40) de l'objectif de projection (11) et insertion d'au moins un deuxième élément optique de rechange dans l'objectif de projection (11) à l'emplacement du deuxième élément optique (40), dans lequel avant l'insertion du deuxième élément optique de rechange dans l'objectif de projection (11), l'au moins un deuxième élément optique de rechange est travaillé, le travail de l'au moins un deuxième élément optique de rechange comprenant la modification de l'épaisseur de matière de l'au moins un deuxième élément optique rechange, et/ou le travail comprenant l'obtention d'au moins une surface de l'au moins un deuxième élément optique de rechange avec une forme de surface asphérique ou uniforme non symétrique en rotation.

2. Procédé selon la revendication 1, dans lequel le travail comprend l'usinage de l'au moins un premier élément optique de rechange.

3. Procédé selon la revendication 1 ou 2, dans lequel l'au moins un premier élément optique de rechange est le premier élément optique (38) après retrait de l'objectif de projection (11) et travail consécutif.

4. Procédé selon l'une quelconque des revendications 1 à 3, dans lequel l'au moins un premier élément optique de rechange est un élément optique essentiellement identique du même type que le premier élément optique retiré (38) dans l'état initial de celui-ci.

5. Procédé selon l'une quelconque des revendications 1 à 4, dans lequel l'étape de réglage d'une qualité d'image comprend les étapes de mesure d'une qualité d'image et réglage de la qualité d'image par déplacement et/ou déformation d'au moins un autre élément optique et/ou modification de la distribution d'indice de l'autre élément optique au cas où cet autre élément optique serait de type réfractif.

6. Procédé selon l'une quelconque des revendications 1 à 5, dans lequel l'objectif de projection (11) est de type à immersion ou de type à double immersion.

7. Procédé selon l'une quelconque des revendications 1 à 6, dans lequel le premier élément optique (38) est en BaF₂, LiF, BaLiF₃, LUAG ou spinelle.

8. Procédé selon l'une quelconque des revendications 1 à 7, dans lequel l'au moins un deuxième élément optique de rechange est conçu en fonction de la différence entre la qualité d'image réelle obtenue par une mesure et la qualité d'image souhaitée.

9. Procédé selon l'une quelconque des revendications 1 à 8, dans lequel l'au moins un deuxième élément optique préalablement retiré (40) est l'au moins un deuxième élément optique de rechange.

10. Procédé selon l'une quelconque des revendications 1 à 9, comprenant en outre, après l'insertion de l'au moins un premier élément optique de rechange, et avant le travail de l'au moins un deuxième élément optique de rechange, la mesure de la qualité d'image de l'objectif de projection (11) sur le terrain, et le calcul d'un profil de correction pour l'au moins un deuxième élément optique de rechange en fonction de la qualité d'image mesurée, et le travail de l'au moins un deuxième élément optique de rechange en fonction du profil de correction calculé.

11. Procédé selon l'une quelconque des revendications 1 à 10, dans lequel l'au moins un deuxième élément optique de rechange est travaillé en fonction de la qualité d'image souhaitée sur la base d'une simulation de l'effet optique du premier élément optique de rechange, et par la suite les premier et deuxième éléments optiques de rechange sont insérés dans l'objectif de projection (11).

12. Procédé selon l'une quelconque des revendications 1 à 11, dans lequel l'au moins un deuxième élément optique (40) est en BaF₂, LiF, BaLiF₃, LUAG ou spinelle.

13. Procédé selon l'une quelconque des revendications 1 à 12, dans lequel le réglage de la qualité d'image comprend le maintien au moins approximatif de la qualité d'image avant la dégradation du système optique.

14. Procédé selon l'une quelconque des revendications 1 à 13, dans lequel le réglage de la qualité d'image comprend la modification de la qualité d'image par rapport à la qualité d'image avant la dégradation du système optique.

15. Procédé selon la revendication 14, dans lequel la modification de la qualité d'image comprend l'amplification et/ou l'atténuation d'au moins un défaut d'image spécifique en fonction de l'exigence opérationnelle dans l'utilisation de l'objectif de projection (11).

16. Procédé selon la revendication 15, dans lequel l'exigence opérationnelle comprend un réglage d'éclairage de l'appareil d'exposition par projection et/ou le type d'objet à imager par l'objectif de projection (11).

17. Procédé selon l'une quelconque des revendications 1 à 16, dans lequel l'au moins un premier élément optique (38) est l'élément de lentille le plus proche du plan image (16).

18. Procédé selon l'une quelconque des revendications 1 à 16, dans lequel l'au moins un deuxième élément optique est l'élément de lentille le plus proche du plan image (16).

19. Procédé selon l'une quelconque des revendications 1 à 18, dans lequel l'au moins un deuxième élément optique (40) est un élément sans puissance optique, en particulier une lame à faces parallèles.
